Europäisches Patentamt

European Patent Office    (11) Numéro de publication:    **0 404 634**

Office européen des brevets    **A1**

(12)    **DEMANDE DE BREVET EUROPEEN**

(21) Numéro de dépôt: **90401617.7**    (51) Int. Cl.⁵: **H03K 19/0185**

(22) Date de dépôt: **12.06.90**

(30) Priorité: **20.06.89 FR 8908182**

(43) Date de publication de la demande:
**27.12.90 Bulletin 90/52**

(84) Etats contractants désignés:
**DE GB NL**

(71) Demandeur: **THOMSON COMPOSANTS
MICROONDES
51, Esplanade du Général de Gaulle
F-92800 Puteaux(FR)**

(72) Inventeur: **Danckaert, Jean-Yves**
**c/o Thomson-CSF, SCPI, Cédex 67**
**F-92045 Paris La Défense(FR)**
Inventeur: **Perea, Ernesto**
**c/o Thomson-CSF, SCPI, Cédex 67**
**F-92045 Paris La Défense(FR)**

(74) Mandataire: **Taboureau, James et al**
**THOMSON-CSF SCPI**
**F-92045 Paris La Défense Cédex 67(FR)**

(54) Circuit d'interface entre deux circuits numériques de natures différentes.

(57) Cette interface constitue une adaptation des signaux de sorties d'un premier circuit, par exemple en silicium, au gabarit des signaux d'entrées dans un second circuit numérique, par exemple en GaAs.

Il comprend un premier étage (A) constitué de deux décaleurs (4, 5, 6) en parallèle, dans lesquels le signal d'entrée (E) et une référence (Ref) sont décalés. Un second étage (B), de type BFL, compare ces deux valeurs, et un troisième étage (C) remet en forme et amplifie. Un quatrième étage (D) peut fournir une valeur complémentaire.

Cette interface est intégrée sur la puce du second circuit numérique, en GaAs.

FIG_1

EP 0 404 634 A1

# CIRCUIT D'INTERFACE ENTRE DEUX CIRCUITS NUMERIQUES DE NATURES DIFFERENTES

La présente invention concerne un circuit électronique qui constitue une interface d'entrée permettant la compatibilité des circuits de type ECL ou MOS, réalisés sur silicium, avec les circuits de type BFL par exemple, réalisés sur GaAs ou matériau III-V. Ce circuit d'interface est lui-même réalisé en GaAs et intégré sur la puce du circuit de type BFL pour laquelle il constitue un plot d'entrée.

On sait que le traitement des signaux hyperfréquences fait appel à des circuits numériques sur GaAs - ou d'autres matériaux rapides, mais GaAs est le plus courant - et à des circuits numériques sur silicium. Les circuits sur GaAs sont plus rapides, et permettent d'atteindre des fréquences que n'atteignent pas les circuits sur silicium, mais ceux-ci sont, dans l'état actuel de la technologie, plus développés et plus intégrés que les circuits GaAs. Il y a donc complémentarité, mais les niveaux de sortie, en tensions, des circuits silicium ne sont pas directement adaptés aux niveaux d'entrée des circuits GaAs. C'est pourquoi une interface est nécessaire.

Pour illustrer l'invention, supposons que le circuit GaAs comprend en entrée une porte BFL (Buffered FET Logic) bien connue, alimentée par exemple entre $V_{dd}$ = 0 V, $V_{ss}$ = -5,5V et avec une tension intermédiaire $V_{rr}$ = -3 V. Pour une telle porte, les niveaux logiques en entrées et en sorties sont de l'ordre : $V_{haut}$ = - 2,5 V environ et $V_{bas}$ = -4,5 V environ, bien que les niveaux de sortie puissent être décalés au moyen d'une ou plusieurs diodes de décalage, selon les tensions d'alimentations choisies.

Cependant, le gabarit des circuits silicium de type ECL est :
- niveau de sortie haut : $-1,03 < V_{oh} < - 0,88$
- niveau de sortie bas : $-1,83 < V_{ol} < - 1,62$
- niveau d'entrée haut : $-1,1 < V_{ih}$
- niveau d'entrée bas : $V_{il} < - 1,5$
et le gabarit des circuits silicium de type CMOS est :
- niveau de sortie haut : $4,9 < V_{oh}$
- niveau de sortie bas : $V_{ol} < 0,1$
- niveau d'entrée haut : $3,5 < V_{ih}$
- niveau d'entrée bas : $V_{il} < 1,5$.

L'interface d'entrée selon l'invention permet de résoudre ce problème de différences entre les tensions de sorties des circuits silicium et les tensions requises en entrée d'un circuit GaAs. Il comprend un premier étage dans lequel le signal d'entrée est décalé puis comparé à une tension de référence, à travers un amplificateur qui constitue un second étage. Un second amplificateur, au troisième étage, remet les signaux en forme, et augmente le gain. Le signal de sortie S est compatible avec un circuit GaAs, soit directement, soit à travers un circuit BFL, monté au quatrième étage, qui fournit le signal complémentaire $\overline{S}$.

De façon plus précise, l'invention concerne un circuit d'interface entre deux circuits numériques de natures différentes, destiné à adapter les tensions de sorties d'un premier circuit au gabarit d'entrée d'un second circuit, caractérisé en ce qu'il comporte :
- un premier étage décaleur, constitué par deux décaleurs montés en parallèle, dont le premier reçoit sur son entrée la tension de sortie du premier circuit numérique, et dont le second décale une tension de référence,
- un second étage comparateur, constitué par un premier inverseur de type BFL, dont le transistor d'entrée reçoit sur sa grille le signal issu du premier décaleur, et sur sa source le signal issu du second décaleur,
- un troisième étage amplificateur constitué par un second inverseur de type BFL, qui délivre sur sa sortie un signal conforme au gabarit d'entrée du second circuit numérique.

L'invention sera mieux comprise par la description qui suit de deux exemples d'application. Cette description s'appuie sur les figures jointes qui représentent :
- figure 1 : schéma électrique d'un circuit interface d'entrée selon l'invention, entre ECL et BFL,
- figure 2 : schéma électrique du circuit d'élaboration de la tension de référence pour le circuit de la figure précédente,
- figure 3 : schéma électrique d'un circuit interface d'entrée selon l'invention, entre CMOS et BFL.

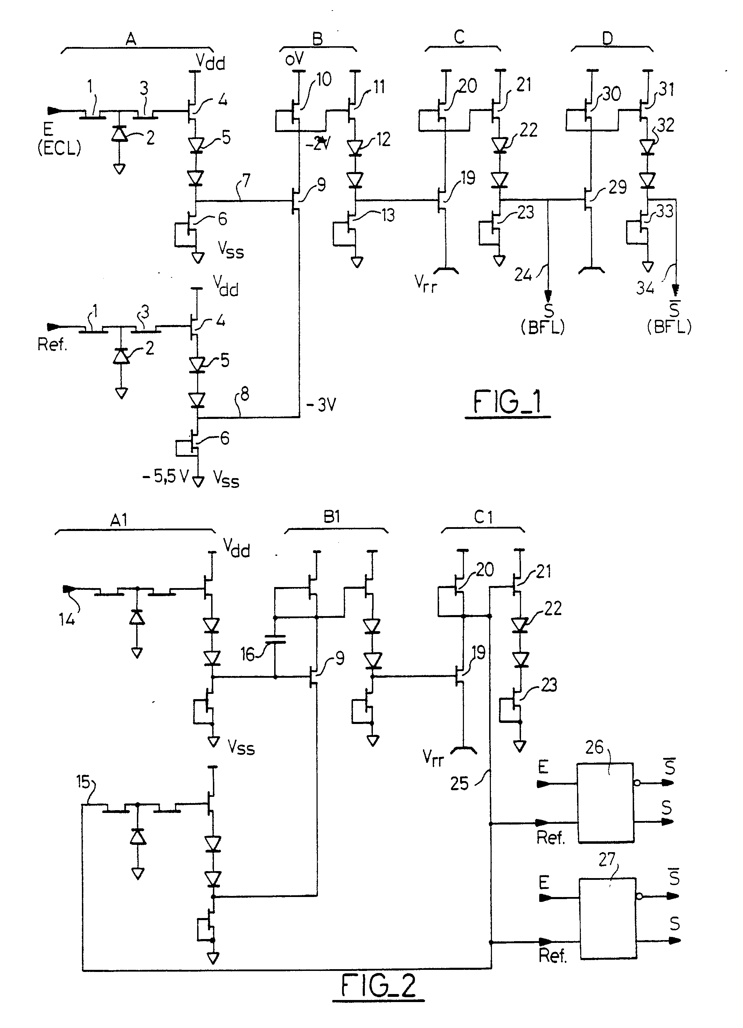

La figure 1 représente le schéma d'une interface réalisé sur GaAs, entre la sortie d'un circuit ECL non représentée, sur silicium, et l'entrée d'un circuit sur GaAs, non représentée.

Pour que le circuit intégré GaAs, muni d'une ou plusieurs interfaces selon l'invention, soit interchangeable avec un circuit ECL sur silicium, et pour conserver les marges de bruit, on impose à l'interface d'entrée un gabarit qui est le même que celui d'un circuit ECL, soit :
$V_{haut}$ = - 1,1 V $V_{bas}$ = - 1,5 V
soit encore une excursion de 400 mV centrée autour de -1,3 V, qu'on conviendra d'appeler tension de basculement.

Ce gabarit permet l'adaptation directe en sortie d'un circuit ECL. Si celui-ci a une tension de sortie $V_{oh}$ comprise entre -0,88 et - 1,03 V, cette tension est plus haute que - 1,1 V : l'interface identifie une tension $Y_{oh}$. Si par contre le circuit ECL a une tension de sortie $V_{oL}$ comprise entre -1,62 et - 1,83 V, cette tension est plus basse que -1,5 V : l'interface identifie une tension $V_{oL}$.

Il est très difficile de respecter ce gabarit avec une structure directe, en raison des variations dues à la technologie - la tension de seuil $V_t$ d'un translstor à effet de champ sur GaAs est définie à plus ou moins 200 mV, soit dans une plage de 400 mV, égale à la plage $V_{haut}$ - $V_{bas}$ -des dérives dues aux variations de température et des variations de tension d'alimentation. On utilise donc une structure de type comparateur.

Ce comparateur - étage A et partiellement B de la figure 1 - comprend deux décaleurs strictement identiques, dont le premier reçoit sur son entrée E un signal ECL compris entre -1,1 et - 1,5 V, et le second reçoit sur son entrée Réf une tension de référence, égale à la tension de basculement corrigée d'une tension d'offset.

Chaque décaleur comprend, après son entrée, un circuit de protection contre les surtensions, composé d'une résistance 1, de l'ordre de 300 ohms pour les tensions citées, d'une diode 2 dont l'anode est réunie à $V_{ss}$ = -5,5 V ou $V_{rr}$ = -3V, et d'une seconde résistance 3, de l'ordre de 600 ohms. Les résistances 1 et 3 sont soit classiques, soit réalisées sous forme de transistors sans grilles ou dont la grille est réunie à la source, comme cela est bien connu.

Chaque décaleur à proprement parler, alimenté entre $V_{dd}$ = OV et $V_{ss}$ = -5,5 V, comprend un transistor d'entrée 4, une pluralité de diodes de décalage 5 et un transistor 6 source de courant. Le signal d'entrée ECL est appliqué sur la grille du transistor 4 du premier décaleur, et le signal de référence externe est appliqué sur la grille du transistor 4 du second décaleur.

Comme ces deux décaleurs sont identiques, ils évoluent parallèlement si la température évolue. Les tensions d'entrée et de référence sont affectées de la même manière par des effets parasites, qui ne modifient pas le signal de sortie.

Le nombre de diodes de décalage 5 dépend des tensions d'alimentations choisies : pour celles qui ont été citées, deux diodes conviennent. Elles amènent un décalage en tension de l'ordre de -2 V.

La sortie 7 du décaleur sur le signal et la sortie 8 du décaleur sur la référence, toutes deux prélevées sur les drains des transistors 6 sources de courant, sont appliquées, respectivement sur la grille et sur la source du transistor d'entrée 9 du second étage B.

Celui-ci est essentiellement un circuit de type BFL, comportant un transistor d'entrée 9 alimenté par un transistor 10 monté en source de courant, et suivi par un transistor suiveur 11, une pluralité de diodes de décalage 12, et un transistor 13 monté en source de courant. Ce schéma est bien connu.

Il est alimenté entre $V_{dd}$ et $V_{ss}$.

La comparaison entre le signal d'entrée E (étage A) et le signal de référence est réalisée par cet inverseur de l'étage B, dont on contrôle le point de basculement par la tension de référence translatée. En effet, on peut considérer que le transistor 9 a sa source connectée à une tension de référence qui n'est pas fixe, mais variable, avec la température par exemple.

Pour commander le troisième étage C, il faut une excursion de tension de l'ordre de -2V sur le drain du transistor d'entrée 9 du second étage. C'est la raison pour laquelle il faut deux décaleurs au premier étage, pour le signal d'entrée et pour la référence. Si $V_{dd}$ = OV et $V_{ss}$ = -5,5 V comme précédemment, on a - 2V de décalage après les diodes 5, environ - 3V sur la source du transistor 9, et de 0 à - 2 V sur le drain de ce même transistor.

Le second étage B constitue également un amplificateur, qui a un gain de 4 à 5.

Le troisième étage C et le quatrième étage D de l'interface selon l'invention sont également des circuits BFL, comme le second étage B, à la seule différence que les sources des transistors d'entrées 19 et 29 sont réunies à une tension de rapport fixe $V_{rr}$ = -3V , tandis que celle du transistor d'entrée 9 est réunie à une tension sujette à variation.

Le troisième étage C est un circuit de remise en forme - il s'agit de signaux numériques - et d'amplification : il apporte un gain supplémentaire de l'ordre de 5. Il délivre sur sa sortie 24 un signal S, d'un niveau compatible avec celui requis à l'entrée d'un circuit sur GaAs : -2,5 à - 4,5V.

Le quatrième étage D est optionnel. Exactement identique au troisième étage C, il permet, si cela est nécessaire, de sortir en 34 le signal complémentaire $\overline{S}$ du signal S fourni en 24.

Il a été dit que la tension appliquée sur l'entrée de référence est égale à la somme de la tension de basculement du circuit ECL (-1,3V) et de la tension d'offset de l'interface GaAs (200mV). Cet offset, ou différence de tension entre les deux entrées, peut varier d'un circuit à l'autre, et il est intéressant de générer la tension de référence en interne, à partir de la tension de basculement du circuit ECL.

Ceci est obtenu à partir d'un circuit d'interface qui est dédié à l'élaboration de la tension de référence.

Montré en figure 2, on voit qu'il est très comparable à l'interface de la figure 1, et comprend :
- un premier étage A1, formé de deux décaleurs identiques,
- un second étage B1, formé par un inverseur BFL
- un troisième étage C1, formé par un autre inverseur BFL.

Il n'y a que deux différences sur le schéma :

- une capacité 16 est introduite entre grille et drain du transistor d'entrée 9 du second étage B1, afin de garantir une bonne stabilité,

- la sortie, prélevée en 25 avant le transistor inverseur 21 du troisième étage C1, est rebouclée sur l'entrée 15 du second décaleur du premier étage A1.

La tension de basculement du circuit ECL, qui constitue une tension de référence "théorique" (- 1,3V) est appliquée sur l'entrée 14 du premier décaleur de l'interface. En fonctionnant sous les mêmes tensions d'alimentation, et avec les mêmes transistors que le circuit de la figure 1, le circuit de la figure 2 génère une tension d'offset entre les entrées 14 et 15. En rebouclant la sortie, en 25, sur l'entrée 15 du second décaleur, on additionne la tension de basculement et la tension d'offset, de sorte que la tension de référence réelle est celle qui est délivrée par la sortie en 25.

Cette tension de référence est celle qui est utilisée sur les entrées de référence d'une pluralité d'interfaces 26, 27... dont chacune est conforme à la figure 1.

On peut encore considérer que, parmi une série d'interfaces intégrés sur la pastille d'un circuit GaAs, l'une est modifiée pour fournir aux autres leur tension de référence, insensible aux variations de technologie, de températures et de tensions d'alimentation.

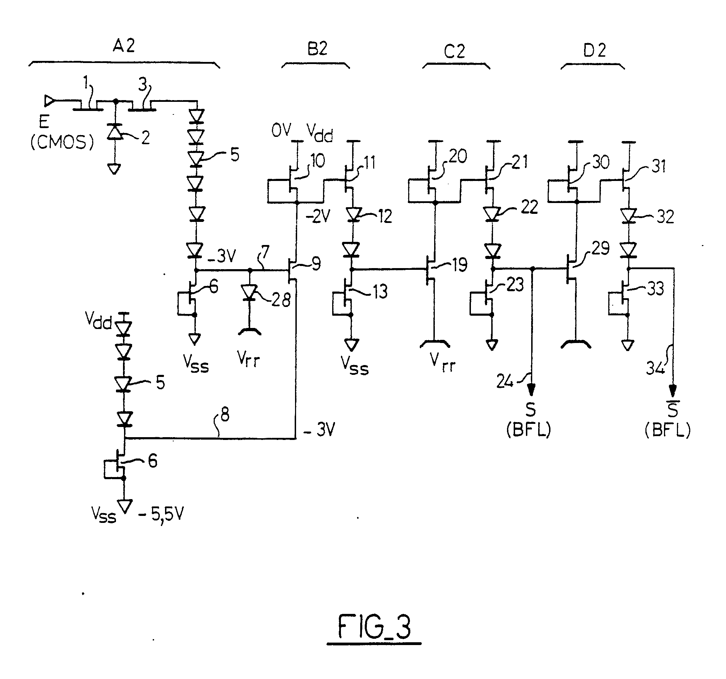

L'interface exposée aux figures 1 et 2 concerne un circuit d'adaptation entre un circuit ECL et un circuit GaAs, en entrée. Celui de la figure 3 concerne une interface entre un circuit CMOS et un circuit GaAs, en entrée.

La même structure générale est adoptée, mais elle est simplifiée parce que les circuits CMOS ont plus de 2 V d'amplitude en sortie ( + 1,5 + 3,5V), et il n'est donc plus nécessaire d'utiliser une tension de référence externe pour obtenir une excursion de 2 V sur le drain du transistor comparateur 9.

Cette interface CMOS/BFL comprend, comme le précédent, un étage A2 décaleur, suivi d'un étage B2 comparateur, d'un étage C2 de remise en forme et amplificateur et, éventuellement, d'un étage D2 qui fournit les deux sorties complémentaires S et $\overline{S}$.

Les étages B2, C2, D2 sont strictement identiques aux étages B, C, D de l'interface ECL/BFL de la figure 1. Seul est modifié l'étage A2 de décaleurs.

Le signal d'entrée, compris entre + 1,5 et + 3,5 V, est adressé sur l'entrée E du premier décaleur. Après le circuit de protection 1 + 2 + 3 - le même qu'en figure 1 - la tension moyenne d'entrée est ramenée de + 2,5 à + 1,5 V : une pluralité de diodes 5, alimentées par une source de courant 6 réunie à $V_{ss}$ = - 5,5 V, décale le signal d'entrée jusqu'à - 3 V environ. Pour les valeurs indiquées, il faut six diodes de décalage 5.

On peut observer que ce décaleur est très proche du décaleur de la figure 1 : l'alimentation $V_{dd}$ et le transistor 4 y sont remplacés par quatre diodes, parce que les signaux CMOS sont d'une ampleur qui le permet.

En sortie 7 de ce premier décaleur, une diode 28 est montée dans le sens passant, vers une tension de rappel $V_{ss}$ = - 3 V. Elle évite que la diode formée par la jonction grille-source du transistor comparateur 9 ne passe en conduction si l'ampleur des signaux est trop importante.

Le second décaleur ne reçoit pas sur son entrée de tension de référence externe : il génère une référence interne, à partir de la tension d'alimentation $V_{dd}$ = 0V qui est décalée à travers quatre diodes 5.

La tension de sortie de ce second décaleur, en 8, est de l'ordre de - 3V.

Les deux tensions de sorties du premier et du second décaleurs sont adressées, respectivement, sur la grille et sur la source du transistor d'entrée 9 du second étage B2, dont le drain connaît une excursion de tension de 2 V. L'utilisation de diodes similaires dans les deux décaleurs permet de minimiser les effets de la température.

Sur un plan plus général, l'adoption de structures similaires - à base de circuits BFL - pour les interfaces d'entrée ECL et CMOS est intéressante dans le cas d'application aux réseaux préimplantés, ou l'on utilise les mêmes éléments.

Comme cela a été déjà précisé, ces interfaces sont réalisées directement sur la pastille d'un circuit intégré en GaAs, et connectées à ses entrées : le circuit GaAs devient alors interchangeable avec un circuit silicium ECL ou CMOS, puisqu'il a le même gabarit d'entrée, mais il travaille plus vite.

L'interface d'entrée selon l'invention est précisée par les revendications suivantes.

## Revendications

1 - Circuit d'interface entre deux circuits numériques de natures différentes, destiné à adapter les tensions de sorties d'un premier circuit au gabarit d'entrée d'un second circuit, caractérisé en ce qu'il comporte :

- un premier étage décaleur (A), constitué par deux décaleurs (4,5,6) montés en parallèle, dont le premier reçoit sur son entrée (E) la tension de sortie du premier circuit numérique, et dont le second décale une tension de référence,

- un second étage comparateur (B), constitué par un premier inverseur de type BFL (9 à 13), dont le transistor d'entrée (9) reçoit sur sa grille le signal issu du premier décaleur, et sur sa source le signal issu du second décaleur,

- un troisième étage amplificateur (C) constitué par un second inverseur de type BFL (19 à 23), qui délivre sur sa sortie (24) un signal (S) conforme au gabarit d'entrée du second circuit numérique.

2 - Circuit d'interface selon la revendication 1, caractérisé en ce qu'il comporte en outre, au moins sur l'entrée du premier décaleur, un circuit de protection contre les surtensions du signal de sortie du premier circuit numérique, ce circuit de protection étant constitué par une première résistance (1), une diode (2) dont l'anode est reliée à une tension ($V_{ss}$ ou $V_{rr}$) d'alimentation, et une seconde résistance (3) réunie à l'entrée du décaleur.

3 - Circuit d'interface selon la revendication 1, caractérisé en ce qu'il comporte en outre un quatrième étage (D), constitué par un troisième inverseur de type BFL (29 à 33), qui délivre sur sa sortie (34) un signal (S) complémentaire du signal (S) délivré par le troisième étage (C).

4 - Circuit d'interface selon la revendication 1, caractérisé en ce qu'il adapte les tensions de sorties d'un premier circuit numérique réalisé sur silicium pour les rendre compatibles avec le gabarit d'entrée d'un second circuit numérique réalisé sur GaAs ou matériaux rapides du groupe III-V.

5 - Circuit d'interface selon la revendication 4, caractérisé en ce que, si le premier circuit numérique est de type ECL, la tension de référence appliquée à l'entrée du second décaleur est une référence externe, chacun des deux décaleurs, identiques, étant constitué par un premier transistor (4), dont la grille reçoit le signal d'entrée (E) ou de référence (Ref), dont le drain est réuni à une première tension d'alimentation ($V_{dd}$), et dont la source est réunie à au moins deux diodes de décalage (5) alimentées par un second transistor (6) monté en source de courant à partir d'une seconde tension d'alimentation ($V_{ss}$).

6 - Circuit d'interface selon la revendication 5, caractérisé en ce que la tension de référence externe est élaborée par un second circuit, de même structure générale (A1, B1, C1), dont l'entrée (14) du premier décaleur reçoit la tension moyenne de basculement des signaux de sortie du circuit ECL, et dont l'entrée (15) du second décaleur reçoit la tension de sortie prélevée (25) sur le drain du transistor de sortie prélevée (25) sur le drain du transistor d'entrée (19) du circuit BFL du troisième étage (C1), ladite tension de sortie (25) constituant la tension de référence (Ref) du circuit d'interface.

7 - Circuit d'Interface selon la revendication 4, caractérisé en ce que, si le premier circuit numérique est de type CMOS, la tension de référence est une référence interne, élaborée par le second décaleur à partir d'une première tension d'alimentation ($V_{dd}$), chacun des deux décaleurs étant constitué d'une pluralité de diodes de décalage (5) en série, alimentées par un transistor (6) monté en source de courant à partir d'une seconde tension d'alimentation ($V_{ss}$), le signal d'entrée (E) étant appliqué sur la première diode du premier décaleur.

8 - Circuit d'interface selon la revendication 7, caractérisé en ce qu'une diode (28) est montée, dans le sens passant, entre la sortie du premier décaleur et une tension de intermédiaire ($V_{rr}$).

9 - Circuit d'interface selon l'une quelconque des revendications 1 à 8, caractérisé en ce qu'il est intégré sur la puce du second circuit numérique, et constitue une adaptation en plots d'entrées.

FIG_1

FIG_2

FIG_3

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | IEEE JOURNAL OF SOLID-STATE CIRCUITS, vol. 23, no. 3, juin 1988, pages 676-680, IEEE, New York, US; G. SCHOU et al.: "Fully ECL-compatible GaAs standard-cell library" * Page 677, colonne de droite, lignes 3-12; figure 5 * | 1-4 | H 03 K   19/0185 |
| A | IEEE GaAs IC SYMPOSIUM TECHNICAL DIGEST, Grenelefé, 28-30 octobre 1986, pages 123-127, IEEE, New York, US; R.C. EDEN et al.: "VBB feedback approach for achieving ECL compatibility in GaAs ICs" * Page 123, colonne de gauche, dernière ligne - page 124, colonne de gauche, ligne 11; figures 2,3 * | 1,2,5,6 | |
| A | EP-A-0 110 701  (HITACHI LTD) * Page 5, ligne 21 - page 8, ligne 10; page 9, ligne 13 - page 11, ligne 10; figures 5,8 * | 1,5,6 | |

**DOMAINES TECHNIQUES RECHERCHES (Int. Cl.5)**

H 03 K

Le présent rapport a été établi pour toutes les revendications

| Lieu de la recherche | Date d'achèvement de la recherche | Examinateur |
|---|---|---|
| LA HAYE | 21-09-1990 | BLAAS D.-L.A.J. |